# EUROPÄISCHE PATENTSCHRIFT

(11) **EP 0 552 716 B1**
(45) Veröffentlichungstag und Bekanntmachung des Hinweises auf die Patenterteilung: **26.05.1999**
(21) Anmeldenummer: 93100729.8
(22) Anmeldetag: 19.01.1993
(51) Int. Cl.: H01L 23/58

(54) **Integrierte Transistorschaltung**
Integrated transistor circuit
Circuit de transistor intégré

(30) Priorität: 24.01.1992 DE 4201947
(43) Veröffentlichungstag der Anmeldung: 28.07.1993
(73) Patentinhaber: TEXAS INSTRUMENTS DEUTSCHLAND GMBH, 85356 Freising (DE)
(72) Erfinder: Bucksch, Walter, W-8050 Freising (DE); Vorel, Anton, W-8330 Eggenfelden (DE)
(74) Vertreter: Schwepfinger, Karl-Heinz, Dipl.-Ing.

(56) Entgegenhaltungen:
- US-A- 4 400 635
- US-A- 4 542 331
- US-A- 4 612 460
- US-A- 4 956 567
- US-A- 5 013 999
- Book no. , 1980, 'HALBLEITER-SCHALTUNGSTECHNIK', U. TIETZE U. CH. SCHENK SPRINGER-VERLAG, BERLIN

## Beschreibung

Die vorliegende Erfindung bezieht sich auf eine integrierte Transistorschaltung gemäß dem Oberbegriff des Patentanspruchs 1. Aus der US-A-4 400 635 ist eine solche Transistorschaltung bekannt.
In integrierten Schaltungen, die laterale pnp-Transistoren mit Antisättigungs-Schottky-Dioden zwischen Basis und Kollektor aufweisen, treten an den Schottky-Übergängen unerwünschte Leckströme auf. Insbesondere bei hohen Temperaturen erhöhen sich die durch die Schottky-Übergänge fließenden Leckströme der in Sperrichtung betriebenen Übergänge dermaßen, daß von den Transistorschaltungen gesteuerte elektronische Schaltungen nicht mehr in der gewünschten Weise gesteuert werden können.

In Sperrichtung betriebene Antisättigungs-Schottky-Dioden weisen bei einer Temperatur von etwa 150° C einen in Sperrrichtung fließenden Leckstrom von etwa 1 µA auf, wenn eine Sperrspannung von etwa 5 V angelegt ist. Dieser Leckstrom fließt zwangsläufig als Basisstrom I_{B} über die Basis-Emitter-Strecke des zugehörigen Transistors und erzeugt demzufolge einen unerwüschten Kollektorstrom I_{c}, der gleich dem mit dem Verstärkungsfaktor h_{fe} multiplizierten Basisstrom des in Emitterschaltung betriebenen Transistors ist. Bei einem Verstärkungsfaktor h_{fe} von etwa 10 beträgt der in Sperrichtung fließende Kollektorstrom etwa 12 µA. Dieser Kollektorstrom kann bereits zu einer Ansteuerung der von der Transistorschaltung gesteuerten Schaltung führen, obwohl noch kein Basisansteuersignal an die Transistorschaltung angelegt ist.

Zur Vermeidung der Auswirkungen der unerwünschten Leckströme wurden Transistoren in integrierten Schaltungen mit (n⁺)- oder (p⁺)-Schutzringen umgeben. Trotz dieser Maßnahmen konnten bei herkömmlichen integrierten Transistorschaltungen infolge von Leckströmen auftretende Substrateffekte nicht genügend verhindert werden. Eine nachteilige Folgewirkung dieser Substrateffekte besteht darin, daß ein inverser Betrieb solcher integrierter Transistorschaltungen nicht möglich ist. Weitere Nachteile herkömmlicher integrierter Transistorschaltungen sind darin zu sehen, daß durch das Vorsehen der Schutzringe die ohnehin knapp bemessene Siliziumfläche übermäßig in Anspruch genommen wird; die durch Schutzringe geprägte Geometrie integrierter Schaltkreise ist daher bei modernen Schaltungen mit hoher Packungsdichte nicht wünschenswert.

Daher ist es Aufgabe der vorliegenden Erfindung, eine integrierte Transistorschaltung mit erheblich verringerten Leckströmen bei erhöhter Betriebstemperatur zu schaffen. Diese Aufgabe wird in einer integrierten Schaltung der oben geschilderten Art mit den im kennzeichnenden Teil des Anspruchs 1 angegebenen Merkmalen gelöst.

Die erfindungsgemäße integrierte Transistorschaltung zeichnet sich dadurch aus, daß der bei hohen Temperaturen und gesperrtem Transistor auftretende Leckstrom nicht über die Basis-Emitter-Diode, sondern über den die Diode und den Widerstand fließt. Die erfindungsgemäße Schaltung besitzt gegenüber herkömmlichen integrierten Schaltungen den Vorteil, daß der Leckstrom vom Emitter über den Widerstand und die Diode zur Basis fließt, so daß eine Verstärkung des Leckstroms um den Verstärkungsfaktor des Transistors ausbleibt. Erfindungsgemäße integrierte Transistorschaltungen eignen sich insbesondere für den Einsatz bei erweitertem Betriebstemperaturbereich.

Vorteilhafte Ausgestaltungen der Erfindung sind in den Unteransprüchen angegeben. Mit der im Anspruch 7 gekennzeichneten integrierten Transistorschaltung wird deren Betrieb in beiden Stromrichtungen ermöglicht.

Ausführungsbeispiele der Erfindung werden anschließend anhand der Zeichnung erläutert. Es zeigen:
- Fig. 1: ein erstes Ausführungsbeispiel der erfindungsgemäßen integrierten Transistorschaltung,
- Fig. 2: ein Anwendungsbeispiel für das anhand von Fig. 1 veranschaulichte Prinzip.

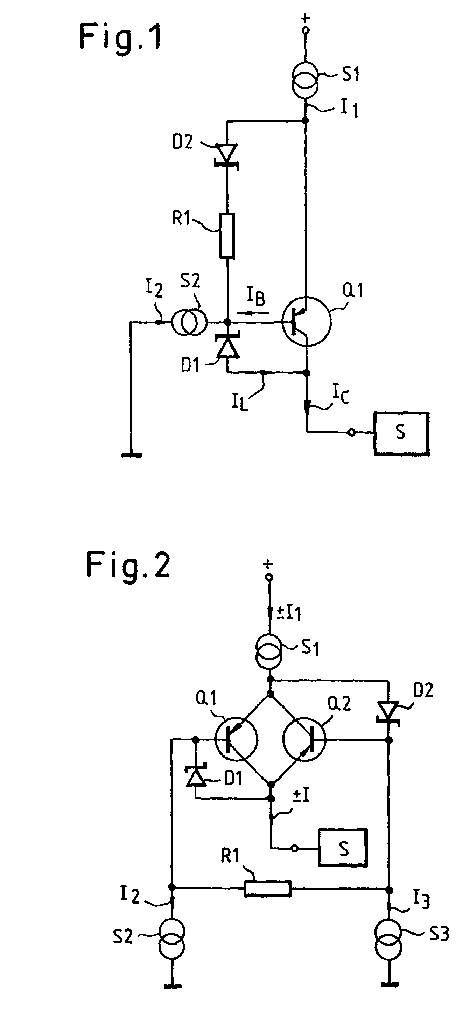

Die in Fig. 1 gezeigte Transistorschaltung enthält einen Transistor Q1 mit einem Emitter, einem Kollektor und einer Basis, einer Antisättigungs-Schottky-Diode D1 zwischen der Basis und dem Kollektor und eine aus einem Widerstand R1 und einer Diode D2 bestehende Serienschaltung zwischen der Basis und dem Emitter. Die Basis des Transistors Q1 ist einerseits über die Schottky-Diode D1 mit dem Kollektor und andererseits über den Widerstand R1 und die Diode D2 mit dem Emitter verbunden. Der Kollektor des Transistors Q1 ist ferner mit einem Eingang einer nicht näher dargestellten Schaltung S verbunden, die mittels des Kollektorstroms angesteuert werden soll. Der Emitter des Transistors Q1 ist mit einer Konstantstromquelle S1 verbunden, die den Strom I₁ liefert. Die Basisansteuerung erfolgt ebenfalls über eine Konstantstromquelle, die den Strom I₂ liefert.

Wie erwähnt, wird der Transistor Q1 durch den von der ersten Stromquelle S1 gelieferten Strom I₁ gespeist und mittels der zweiten Stromquelle S2 angesteuert. Wenn über die Stromquelle S2 ein Strom I₂ fließt, so fließt ein Basisstrom I_{B} und öffnet den Transistor Q1. Über den leitenden Transistor Q1 wird dann die Schaltung S angesteuert, indem der Schaltung S der Kollektorstrom I_{c} zugeführt wird. Wenn kein Basisstrom I_{B} fließt, sperrt der Transistor Q1, so daß kein Kollektorstrom I_{c} mehr fließt. Bei höheren Temperaturen fließt jedoch durch die Schottky-Diode D1 ein Leckstrom I_{L}, der für den Transistor wie ein Basisstrom wirkt. Ohne Vorsehen besonderer Maßnahmen würde dieser Basisstrom zu einem durch die Emitter-Kollektor-Strecke des Transistors Q1 fließenden Kollektorstrom I_{c} führen, der gleich dem mit dem Verstärkungsfaktor h_{fe} des Transistors multiplizierten Basisstrom I_{B} ist. Je nach der Größe des Verstärkungsfaktors und der Höhe der Temperatur könnte der Kollektorstrom I_{c} so weit ansteigen, daß die Schaltung S angesteuert wird, obwohl die Stromquelle S2 abgeschaltet ist, also keine tatsächliche gewollte Basisansteuerung des Transistors Q1 vorhanden ist.

Zur Vermeidung dieses bei höheren Temperaturen auftretenden Effekts kann der Leckstrom über den von der Schottky-Diode D2 und dem Widerstand R1 gebildeten Nebenschlußweg zur Basis-Emitter-Diode des Transistors Q1 fließen und unterliegt daher nicht mehr der Verstärkung durch den Transistor Q1. Weil die Durchlaßspannung der Schottky-Diode kleiner als die Durchlaßspannung der Basis-Emitter-Diode des Transistors ist, wird der Nebenschlußweg bei einem Temperaturanstieg eher leitend als die Emitter-Basis-Strecke des Transistors. Dies bedeutet, daß auch bei höheren Temperaturen keine auf den Leckstrom I_{L} zurückzuführende Erhöhung des Kollektorstroms I_{c} des Transistors Q1 auftritt, die zu einer unerwünschten Ansteuerung der Schaltung S führen könnte.

Damit die beschriebene Transistorschaltung optimal funktioniert, muß die Schottky-Diode D2 so dimensioniert sein, daß ihre Durchlaßspannung kleiner als die Emitter-Basis-Spannung des Transistors Q1 ist. Gleichfalls setzt ein optimales Funktionieren der Transistorschaltung voraus, daß der Widerstand so dimensioniert ist, daß er bei hohen Temperaturen (150° C) und gesperrtem Transistor Q1 eine nur geringfügige Wirkung zeigt, d.h. daß der Leckstrom ungehindert über die Diode D2 und den Widerstand R1 fließen kann. Bei niedrigen Temperaturen (-40° C) und bei durchgeschaltetem Transistor Q1 soll der Widerstand R1 dagegen ausreichend hoch sein, so daß nur eine hochohmige Verbindung zwischen Emitter und Basis vorhanden ist. Wird der Widerstand R1 wie oben beschrieben dimensioniert, so ist der durch ihn fließende Strom wesentlich geringer als der Basisstrom, wenn der Transistor Q1 leitet, und in etwa gleich dem Leckstrom der Diode D1, wenn der Transistor Q1 sperrt.

Bei der Herstellung der erfindungsgemäßen integrierten Transistorschaltung kann der Widerstand R1 entweder in einer separaten Wanne integriert werden, oder er kann zusammen mit der Schottky-Diode D2, dem Transistor Q1 und der Schottky-Diode D1 in einer Wanne untergebracht werden. Eine besonders vorteilhafte und platzsparende Anordnung der integrierten Transistorschaltung wird erhalten, wenn der Widerstand R1 als Teil der Schottky-Diode D2 ausgebildet wird, die zusammen mit dem Transistor Q1 und der Schottky-Diode Dl in einer Wanne integriert ist.

Eine vorteilhafte Anwendung des in der Schaltung von Fig. 1 verwirklichten Prinzips bei einem bidirektionalen Schalter ist in Fig. 2 gezeigt. Die Schaltung von Fig. 2 unterscheidet sich lediglich dadurch von der Schaltung aus Fig. 1, daß sie einen zweiten, zum Transistor Q1 antiparallel geschalteten Transistor Q2 aufweist. Der Kollektor und der Emitter des zweiten Transistors Q2 sind mit Emitter bzw. Kollektor des Transistors Q1 verbunden. Die Basis des zweiten Transistors Q2 ist mit dem mit dem Widerstand R1 verbundenen Anschluß der Diode D2 verbunden und an eine weitere Stromquelle S3 angeschlossen. Die Diode D2 ist dabei gleichzeitig die Antisättigungs-Schottky-Diode des Transistors Q2. Mittels dieser Ausführungsform der Transistorschaltung kann zu der anzusteuernden Schaltung sowohl ein positiver Strom als auch ein negativer Strom durchgeschaltet werden, je nachdem, welchen Strom die Stromquelle S1 liefert.

Liefert die Stromquelle S1 einen positiven Strom I₁, so öffnet Transistor Q1, und ein Strom I₂ fließt über die Basis in die Stromquelle S2. Der Basisstrom ist in etwa dem Strom I₂ gleich, den die Stromquelle S2 zieht. Der anzusteuernden Schaltung S wird über den Kollektor des Transistors Q1 ein positiver Strom I zugeführt, der ungefähr gleich dem Strom I₁ - I₂ - I₃ ist. Die Stromquellen S2 und S3 sind so dimensioniert, daß sie beispielsweise bei einem Strom I₁ von etwa 300 µA lediglich einen Strom von etwa 50 µA ziehen.

In diesem Zustand der Schaltung ist der Transistor Q2 gesperrt, der nur dann zum Einsatz kommt, wenn ein negativer Strom an der Stromquelle S1 zur anzusteuernden Schaltung S durchgeschaltet werden soll. Bei erhöhten Temperaturen fließt jedoch über die Antisättigungs-Schottky-Diode D2 des Transistors Q2 ein Leckstrom, der auch als Basisstrom für diesen Transistor wirkt. Der aufgrund dieses Leckstroms fließende Basisstrom des Transistors Q2 kann über die Schottky-Diode D1 und den Widerstand R1 abgeleitet werden, so daß er nicht über die Emitter-Kollektor-Strecke des Transistors Q2 fließen muß; er wird demnach auch nicht durch den Verstärkungsfaktor h_{fe} dieses Transistors verstärkt. Eine Temperaturerhöhung hat somit keine nennenswerte Veränderung des Stroms zur Folge, der bei gesperrten Transistoren Q1 und Q2 zur Schaltung S fließt.

Wird der Transistor Q1 durch Abschalten der Stromquelle S2 gesperrt, soll kein Strom mehr zur Schaltung S fließen. Bei höheren Temperaturen fließen jedoch Leckströme durch die Dioden D1 und D2, die jeweils wie Basisströme für die Transistoren Q1 bzw. Q2 wirken. Die Serienschaltung aus der Diode D2 und dem Widerstand R1 einerseits und die Serienschaltung aus der Diode D1 und dem Widerstand R1 andererseits wirken jedoch wie Nebenstromwege zwischen dem Emitter und der Basis des Transistors Q1 bzw. zwischen dem Emitter und der Basis des Transistors Q2, so daß der jeweilige von dem Basisstrom erzeugte Strom in der Zuleitung zur Schaltung S nicht über die Emitter-Kollektor-Strecke des jeweiligen Transistors fließen muß und somit nicht der Stromverstärkung unterliegt. Der aufgrund der Leckströme fließende Ruhestrom in der Ansteuerleitung der Schaltung S bleibt daher auf einem vernachlässigbaren kleinen Wert.

Die in Fig. 2 dargestellte zweite Ausführungsform der beschriebenen Schaltung kann, wie erwähnt, auch mit umgekehrten Stromrichtungen betrieben werden. Die obige Wirkungsbeschreibung gilt dabei ebenfalls, allerdings ist im Durchschaltzustand nicht der Transistor Q1, sondern der Transistor Q2 leitend.

Ein besonderer Vorteil der in Fig. 2 abgebildeten Schaltung ist der, daß keine zwei weiteren Dioden und nur ein Widerstand zur Umleitung des Leckstroms benötigt werden. Der Leckstrom wird nämlich jeweils über die Antisättigungsdiode des sperrenden Transistors und über den Widerstand R1 umgeleitet.

## Patentansprüche

1. Integrierte Transistorschaltung mit einem bipolaren Transistor (Q1), dessen Kollektor mit einem Eingang einer anzusteuernden Schaltung (S) verbindbar ist, und zwischen dessen Basis und Kollektor eine Antisättigungsdiode (D1) liegt, wobei der Emitter und die Basis des Transistors (Q1) über eine Serienschaltung aus einer Diode (D2) und einem Widerstand (R1) miteinander verbunden sind, dadurch gekennzeichnet, daß der Widerstand (R1) so dimensioniert ist, daß durch ihn ein gegenüber dem Basisstrom vernachlässigbar geringer Strom fließt, wenn der Transistor (Q1) leitet, und ein in etwa dem Leckstrom der Antisättigungsdiode (D1) gleicher Strom fließt, wenn der Transistor sperrt.

2. Integrierte Transistorschaltung nach Anspruch 1, dadurch gekennzeichnet, daß die Diode (D2) eine Schottky-Diode ist und eine niedrigere Durchlaßspannung (U_{D}) als die Emitter-Basisspannung (U_{EB}) des Transistors aufweist.

3. Integrierte Transistorschaltung nach Anspruch 1 oder 2, dadurch gekennzeichnet, daß der Transistor (Q1) ein lateraler pnp-Schottky-Transistor ist.

4. Integrierte Transistorschaltung nach einem der vorhergehenden Ansprüche, dadurch gekennzeichnet, daß der Widerstand (R1) in einer seperaten Wanne eines Halbleitersubstrats integriert ist.

5. Integrierte Transistorschaltung nach einem der Ansprüche 1 bis 3, dadurch gekennzeichnet, daß der Widerstand (R1) und die Diode (D2) zusammen mit dem Transistor (Q1) und der Antisättigungsdiode (D1) in einer Wanne eines Halbleitersubstrats integriert ist.

6. Integrierte Transistorschaltung nach einem der Ansprüche 1 bis 3, dadurch gekennzeichnet, daß der Widerstand (R1) als Teil der Diode (D2) in der Wanne des Transistors (Q1) und der Antisättigungsdiode (D1) integriert ist.

7. Integrierte Transistorschaltung nach einem der vorhergehenden Ansprüche, dadurch gekennzeichnet, daß Emitter und Kollektor des Transistors (Q1) mit Kollektor bzw. Emitter eines zweiten Transistors (Q2) verbunden sind und daß der mit dem Widerstand (R1) verbundene Anschluß der Diode (D2) mit der Basis des zweiten Transistors verbunden ist.

8. Integrierte Transistorschaltung nach Anspruch 7, dadurch gekennzeichnet, daß der zweite Transistor (Q2) ein lateraler pnp-Schottky-Transistor ist.

## Claims

1. An integrated transistor circuit comprising a bipolar transistor (Q1) the collector of which is connectable to an input of a circuit (S) to be signalled, and between the base and collector of which an anti-saturation diode (D1) is located, the emitter and the base of the transistor (Q1) being connected to each other via a series arrangement of a diode (D2) and a resistor (R1), characterized in that the resistor (R1) is so dimensioned that it passes a current which is negligibly small as compared to the base current when the transistor (Q1) is ON and which is roughly the same as the leakage current of the anti-saturation diode (D1) when the transistor is OFF.

2. The integrated transistor circuit as set forth in claim 1, characterized in that the diode (D2) is a Schottky diode (D2) and comprises a forward voltage (U_{D}) which is lower than the emitter-base voltage (U_{EB}) of the transistor.

3. The integrated transistor circuit as set forth in claim 1 or 2, characterized in that the transistor (Q1) is a lateral pnp Schottky transistor.

4. The integrated transistor circuit as set forth in any of the preceding claims, characterized in that the resistor (R1) is integrated in a separate trough of a semiconductor substrate.

5. The integrated transistor circuit as set forth in any of the claims 1 to 3, characterized in that the resistor (R1) and the diode (D2) are integrated together with the transistor (Q1) and the anti-saturation diode (D1) in a trough of a semiconductor substrate.

6. The integrated transistor circuit as set forth in any of the claims 1 to 3, characterized in that the resistor (R1) is integrated as part of the diode (D2) in the trough of the transistor (Q1) and of the anti-saturation diode (D1).

7. The integrated transistor circuit as set forth in any of the preceding claims, characterized in that the emitter and collector of the transistor (Q1) are connected to the collector and emitter respectively of a second transistor (Q2) and that the diode (D2) terminal connected to the resistor (R1) is connected to the base of the second transistor.

8. The integrated transistor circuit as set forth in claim 7, characterized in that the second transistor (Q2) is a lateral pnp Schottky transistor.

## Revendications

1. Circuit intégré à transistor, comportant un transistor bipolaire (Q1), dont le collecteur peut être relié à une entrée d'un circuit (S) devant être commandé et entre la base et le collecteur duquel est disposée une diode d'anti-saturatipn (D1), l'émetteur et la base du transistor (Q1) étant reliés entre eux par l'intermédiaire d'un circuit série formé d'une diode (D2) et d'une résistance (R1), caractérisé en ce que la résistance (R1) est dimensionnée de telle sorte qu'un courant, qui est faible au point d'être négligeable par rapport au courant de base, circule dans cette résistance lorsque le transistor (Q1) est conducteur, et qu'un courant égal approximativement au courant de fuite de la diode d'anti-saturation (D1) circule lorsque le transistor est bloqué.

2. Circuit intégré à transistor selon la revendication 1, caractérisé en ce que la diode (D2) est une diode Schottky et possède une tension à l'état passant (U_{D}), qui est inférieure à la tension émetteur-base (U_{EB}) du transistor.

3. Circuit intégré à transistor selon la revendication 1 ou 2, caractérisé en ce que le transistor (Q1) est un transistor pnp-Schottky latéral.

4. Circuit intégré à transistor selon l'une des revendications précédentes, caractérisé en ce que la résistance (R1) est intégrée dans une cuvette séparée d'un substrat semiconducteur.

5. Circuit intégré à transistor selon l'une des revendications 1 à 3, caractérisé en ce que la résistance (R1) et la diode (D2) sont intégrées conjointement avec le transistor (Q1) et la diode d'anti-saturation (D1) dans un substrat semiconducteur.

6. Circuit intégré à transistor selon l'une des revendications 1 à 3, caractérisé en ce que la résistance (R1) est intégrée en tant que partie de la diode (D2) dans la cuvette du transistor (Q1) et de la diode d'anti-saturation (D1).

7. Circuit intégré à transistor selon l'une des revendications précédentes, caractérisé en ce que l'émetteur et le collecteur du transistor (Q1) sont reliés au collecteur et à l'émetteur d'un second transistor (Q2) et que la borne, reliée à la résistance (R1), de la diode (D2) est reliée à la base du second transistor.

8. Circuit intégré à transistor selon la revendication 7, caractérisé en ce que le second transistor (Q2) est un transistor pnp-Schottky latéral.
